# EUROPEAN PATENT SPECIFICATION

(11) **EP 3 796 401 B1**
(45) Date of publication and mention of the grant of the patent: **05.11.2025**
(21) Application number: 18919298.2
(22) Date of filing: 18.05.2018
(51) Int. Cl.: H10H 20/812, H10H 20/816, H10H 20/825

(54) **LIGHT-EMITTING DIODE EPITAXIAL WAFER**
EPITAKTISCHES WAFER FÜR LICHTEMITTIERENDE DIODE
PLAQUETTE ÉPITAXIALE POUR DIODE ÉLECTROLUMINESCENTE

(43) Date of publication of application: 24.03.2021
(73) Proprietor: Xiamen San'an Optoelectronics Co., Ltd., Fujian 361100 (CN)
(72) Inventor: LIN, Wen-yu, Xiamen, Fujian 361009 (CN); YEH, Meng-hsin, Xiamen, Fujian 361009 (CN); LO, Yun-ming, Xiamen, Fujian 361100 (CN); TSENG, Chien-yao, Xiamen, Fujian 361100 (CN); CHANG, Chung-ying, Xiamen, Fujian 361100 (CN)
(74) Representative: Petraz, Gilberto Luigi
(86) International application number: PCT/CN2018/087515
(87) International publication number: WO 2019/218350

(56) References cited:
- EP-A1- 1 248 303
- EP-A2- 2 701 210
- CN-A- 107 112 391
- CN-A- 107 681 027
- CN-A- 107 819 058
- CN-U- 206 471 346
- JP-A- 2016 181 553
- US-A1- 2016 118 537
- US-A1- 2017 033 260
- US-A1- 2017 033 260

## Description

### TECHNICAL FIELD

The present invention relates to a field of epitaxy of semiconductor devices, and more particularly to a light emitting diode with a high Energy Bandgap (Eg) multi-quantum well.

### BACKGROUND

Light Emitting Diode (LED) is a semiconductor solid-state light emitting device, which uses a semiconductor PN junction as a light emitting material to directly convert electricity into light. The light emitting diode generally includes epitaxial structures of N-type semiconductor layer, light emitting region and P-type semiconductor layer. A multi-quantum well structure is usually used in the light emitting region. The multi-quantum well structure is initially composed of two different semiconductor material films stacked on each other to form a potential well for electrons or holes. The light emission of the multi-quantum well is realized by the radiation recombination of electron hole pairs confined in the well layer. In use, when the voltage is applied to both ends of the LED, carriers enter the multi-quantum well through tunneling, diffusion or thermal emission, and most of the injected carriers are trapped and confined by the multi-quantum well. The light is emitted through the radiation recombination in the well layer, and the wavelength of light emission depends on the energy bandgap of the material used. The brightness of light emission depends on the internal quantum efficiency and the light extraction efficiency, while the internal quantum efficiency is mainly adjusted by the multi-quantum well structure, such as the depth, thickness, composition and structure of the well. US-A1-2017/033260 discloses a multi-quantum well structure for LEDs, which includes a plurality of sequentially arranged well-barrier structures each including a well layer, a barrier layer, and an intermediate layer between the well layer and the barrier layer. The band gap of the barrier layer is larger than the band gap of the intermediate layer, and the band gap of the intermediate layer is larger than the band gap of the well layer. The thickness distribution of the well-barrier structure varies (e.g., the well layer gradually increases and the intermediate layer gradually decreases) to reduce the stress in the multi-quantum well structure and to ensure that the light emitted by the different trap-barrier structures has the similar or same wavelength.
EP-A1-1 248 303 discloses a light emitting device including an active layer made of nitride semiconductor containing In, the light emitting device having an active layer between the n-type semiconductor layer and the p-type semiconductor layer. The active layer comprises a well layer made of Inₓ₁Ga₁₋ₓ₁N (x1 > 0) containing In and a first barrier layer made of Al_{y2}Ga_{1-y2}N (y2 > 0) containing Al formed on the well layer. JP-A-2016181553 discloses a semiconductor light-emitting devicehaving a superlattice structure layer on an n-type semiconductor layer; an electron injection control layer located thereon, which includes a first control layer and a second control layer; and a luminescent layer on the electron injection control layer, which is arranged by repeating a barrier layer and a quantum well layer. The second control layer of the electron injection control layer has the same composition and thickness as those of the quantum well layer of the luminescent layer, or a composition smaller than that of the quantum well layer of the luminescent layer in band gap. The first control layer of the electron injection control layer has a first control well layer in contact with a second semiconductor layer of the superlattice structure layer; and a second control well layer in contact with the second control layer. The first control layer is located between the first control well layer and the second control well layer.
US-A1-2016/118537 describes a semiconductor light-emitting element having a first semiconductor layer, an active layer having a multiple quantum well structure in which a plurality of well layers and a plurality of barrier layers are alternately layered, an electron block layer, and a second semiconductor layer. Among the barrier layers, an endmost barrier layer closest to the second semiconductor layer includes a first endmost barrier layer part and a second endmost barrier layer part formed on a side closer to the second semiconductor layer than the first endmost barrier layer part and having a larger band gap than that of the first endmost barrier layer part. The first endmost barrier layer part has a band gap that is larger than that of each of the well layers and is smaller than that of each barrier layer other than the endmost barrier layer.
EP-A2-2 701 210 discloses a light emitting device, a light emitting device package and a lighting system. The light emitting device includes a first conductive semiconductor layer; a second conductive semiconductor layer on the first conductive semiconductor layer; and an active layer between the first and second conductive semiconductor layers, the active layer including a plurality of well layers and a plurality of barrier layers, wherein the well layers include a first well layer and a second well layer adjacent to the first well layer, the barrier layers include a first barrier layer disposed between the first and second well layers, the first barrier layer includes a plurality of semiconductor layers having an energy bandgap wider than an energy bandgap of the first well layer, and at least two layers of the plurality of semiconductor layers which is adjacent to the first and second well layers have aluminum contents greater than that of the other layer.

### SUMMARY

The invention is set out in the appended set of claims.

### BRIEF DESCRIPTION OF THE DRAWINGS

The accompanying drawings are used to provide a further understanding of the present invention, and constitute a part of the specification. Together with the embodiments of the present invention, they are used to explain the present invention and do not constitute a limitation to the present invention. In addition, the figure data is a descriptive summary, is not drawn to scale.
FIG. 1 is a schematic structural diagram of a first sample of a light emitting diode according to a first embodiment of the present invention.
FIGS. 2a and 2b are TEM diagrams of a first sample of a light emitting diode according to a first embodiment of the present invention.
FIG. 3 is an X-ray spectrum line scanning component profile analysis diagram of a quantum well of a light emitting diode.
FIG. 4 is a scatter diagram of wavelength-brightness according to a first embodiment of the present invention.
FIG. 5-8 is a schematic structural diagram of a light emitting diode according to a second through seventh embodiment of the present invention.

### DETAILED DESCRIPTION OF EMBODIMENTS

In order to make the substantive characteristics and practicality of the light emitting diode with a high energy bandgap superlattice layer according to the present invention easier to understand, hereinafter, several specific embodiments of the present invention will be further described in detail with reference to the accompanying drawings. However, the following illustration and description of the embodiments do not limit the scope of the present invention.

It should be understood that the terminology used in the present invention is merely for the purpose of describing specific embodiments and is not intended to limit the present invention. As used in the present invention, singular forms "a", "one" and "said" are also intended to include plural forms, except as clearly indicated in the context. It should be further understood that, when the terms "include", "comprise", "contain" are used in the present invention, they are used to indicate the presence of the stated features, entirety, steps, operations, elements, and/or packages without excluding the presence or addition of one or more other features, entirety, steps, operations, elements, packages, and/or combinations thereof.

Unless otherwise defined, all terms (including technical and scientific terms) used in the present invention have the same meaning as commonly understood by those of ordinary skill in the art to which the present invention belongs. It should be further understood that the terms used in the present invention should be understood as having meanings consistent with the meanings of these terms in the context of this specification and related fields, and should not be understood in an idealized or overly formal sense, unless explicitly defined as such in the present invention.

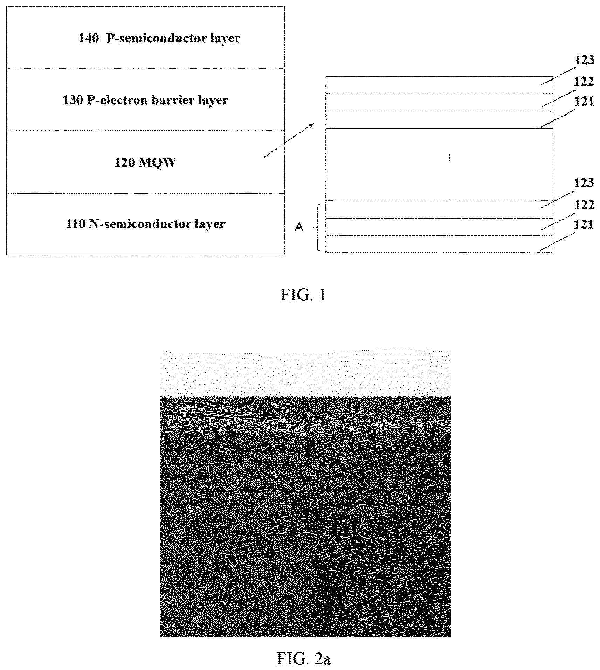

The first preferred embodiment of the present invention is an epitaxial structure of a gallium nitride-based light emitting diode, but is not limited thereto. Alternatively, the light emitting diode can have either face up chip structure or a flip chip structure. FIG. 1 shows a schematic diagram of an epitaxial structure employed in the light emitting diode. The epitaxial structure includes, from bottom to top, an N-type conductive layer 110, a light emitting layer 120, a P-type electron barrier layer 130, and a P-type conductive layer 140. The epitaxial structure of the light emitting diode is obtained by MOCVD growth on an epitaxial growth substrate. A chip is obtained by transferring the P-type conductive layer side of the epitaxial structure onto a permanent substrate. The embodiment is obtained by using the existing vertical light emitting diode manufacture method.

The N-type conductive layer 110 and the P-type conductive layer 140 are made of a nitride-based semiconductor layer, which has a wider bandgap than the light emitting layer 120. In specific embodiment, an AlGaN layer or a GaN may be used.

The P-type electron barrier layer 130 is located between the light emitting layer 120 and the P-type conductive layer 140. The energy bandgap of the P-type electron barrier layer 130 is larger than the energy bandgap of the P-type conductive layer 140. The P-type electron barrier layer 130 is made of a nitride-based semiconductor layer containing Al and may be a single or multi-layer structure, such as a superlattice structure.

The light emitting layer 120 is composed of at least two periodic structures, each of which generally contains at least two thin layers of different materials. The material of the thin layers is the nitride-based semiconductor layer, preferably unintentionally doped. The at least two periodic structures A each includes a first sub-layer, a second sub-layer and a third sub-layer. A relationship of an energy bandgap Eg1 of the first sub-layer, an energy bandgap Eg2 of the second sub-layer and an energy bandgap Eg3 of the third sub-layer is Eg1<Eg2<Eg3. The first sub-layer serves as a well, the second sub-layer serves as a barrier, and the third sub-layer is superposed on the layer of the barrier to form an additional potential barrier that provides better confinement effect. During the operation of the device, the energy band is inclined, which is caused by the external biasing situation, and thus the high bandgap potential barrier spike (Eg3) can further prevent the overflow of the carriers and increase the radiation recombination efficiency so as to increase the brightness. In addition, the high bandgap means better insulation. For example, growing a proper thickness of Eg3 layer in each layer of MQW will better block the reverse current and can reduce the leakage current after aging test. In addition, the stepped potential barrier (Eg2<Eg3) can also help to adjust the stress between the well and the barrier in the whole MQW. The Eg3 of the third sub-layer is preferably larger than Eg2 at least 1.5eV to ensure its confinement effect on the carriers and to effectively prevent the overflow of the carriers. The thickness of the third sub-layer is less than 30 angstroms. The thickness of the first sub-layer and the second sub-layer is used to adjust the thicknesses of the well and the barrier. If the thickness of the third sub-layer is relatively small, the confinement effect provided by the additional potential barrier is not obvious enough. If the thickness of the third sub-layer is relatively large, the conductivity of the third sub-layer will be poor, the performance of the light emitting region is reduced, and the voltage is increased.

The structure is more suitable for the nitride-based light emitting diode with a light emitting wavelength of 210-420nm. Preferably, the periodic structure A may adopt InGaN/AlGaN/AlN, GaN/AlGaN/AlN, InGaN/AlInGaN/AlN or InGaN/GaN/AlN. For example, the first sub-layer 121 may adopt InₓGa₁₋ₓN, where a value of x can adjust the light emitting wavelength. If x is larger, the light emitting wavelength is shorter; if x is smaller, the light emitting wavelength is longer. The second sub-layer 122 may adopt In_{y}Al_{z}Ga_{1-y-z}N (where 0 ≤ y ≤ 1, 0 ≤ z ≤ 1, y+z ≤ 1 whereby according to the invention y = 0), and the third sub-layer 123 is in accordance with the invention Al_{w}Ga_{1-w}N (w is between 0 to 1, whereby in accordance with the invention 0.95 ≤ w ≤ 1). At the same time, the Eg1 can be adjusted by the In content of the first sub-layer, the Eg2 can be adjusted by the Al and In content of the second sub-layer, and the Eg3 can be adjusted by the Al content of the third sub-layer. The Eg1 of the first sub-layer is preferably 3.3-3.5eV, more preferably 3.3-3.4eV, and the thickness is preferably less than 300 angstroms. The Eg2 of the second sub-layer is preferably 3.55-3.9eV, and more preferably 3.59-3.70 eV, and the thickness is preferably less than 300 angstroms, and according to the invention 50-300 angstroms. The Eg3 of the third sub-layer is greater than 1.5eV. More preferably, the third sub-layer is AIN, Eg3 is 6.2eV, and the thickness of the third sub-layer is 10 to 15 angstroms. In addition, the nitride light emitting diode mainly adopts In and Al doping to obtain the well and barrier materials of the quantum well, and the arrangement of the lattice constants is InN<GaN<AlN. According to the present invention, it is achieved that the multi-quantum well structure is formed by a stack of materials with stepped lattice constants (for example, the first sub-layer InGaN< second sub-layer InAlGaN or AlGaN< third sub-layer AlGaN or AlN). This helps to adjust the lattice matching of the entire MQW well barrier, release stress, and improve the crystal quality. On the contrary, if the Eg3 is set between the energy bandgap of the well and the barrier, the carrier migration is more difficult than in the stepped structure of the present invention, and for the Eg3, the stress difference between the third sub-layer and the first sub-layer is greater, and the stress release ability is less than in the stepped structure of the present invention.

The followings are two kinds of ultraviolet LED vertical chip samples with 365-370nm main light emitting wavelength. The permanent substrate is a silicon substrate, and the P-type electron barrier layer is AlGaN. The chip size is 325µm*325µm. Sample I adopts the epitaxial structure shown in FIG. 1, where the growth substrate is sapphire, the N-type semiconductor layer is AlGaN, the P-type semiconductor layer is AlGaN, the light emitting layer 120 specifically adopts a high bandgap structure formed by an alternately stacked structure of three layers of InₓGa₁₋ₓN (x content is 0.5 at%, the average thickness of the layer is 76 angstroms)/Al_{z}Ga_{1-z}N (z content is 8at%, the average thickness of the layer is 177 angstroms)/AlN (the average thickness of the layer is 10 angstroms), and the number of periods is 5, which forms a high energy bandgap structure. The difference between sample II and sample I is that the multi-quantum well adopts a conventional stacked structure of InGaN and AlGaN, and the other layers of the sample II are the same as that of the sample I. The quantum well of the sample II adopts an alternately stacked structure of two layers of InₓGa₁₋ₓN (x content is 0.5 at%, the average thickness of the layer is 76 angstroms)/Al_{z}Ga_{1-z}N (z content is 8at%, the average thickness of the layer is 177 angstroms) to form a period, and the number of periods is 5.

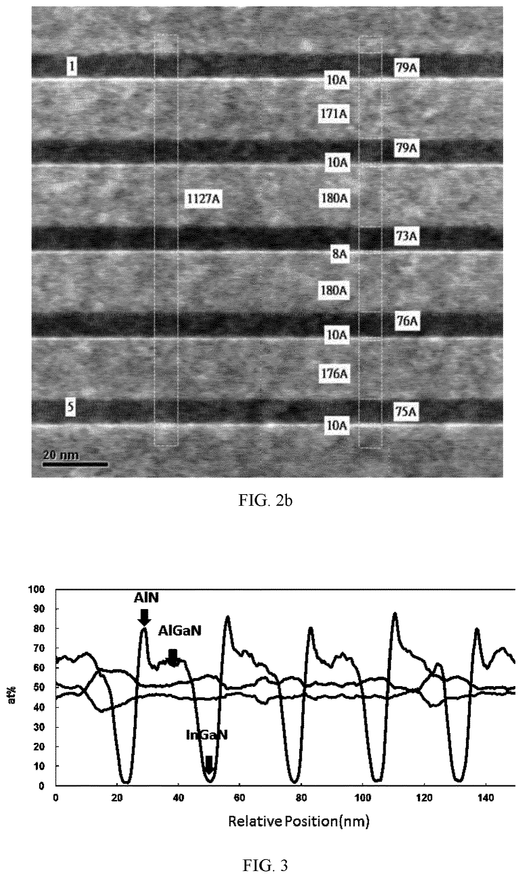

FIG. 2a is a transmission electron microscope diagram of sample I. It can be seen from the diagram that the multi-quantum well of the light emitting layer is a stacked structure in five periods. FIG. 2b is a transmission electron microscope diagram showing a magnification of the multi-quantum well layer of sample I. The thickness distribution of the first sub-layer, the second sub-layer and the third sub-layer in each period structure can be measured.

FIG. 3 is an EDX linear scanning component profile analysis diagram of multi-quantum wells. The number of periodic structures and the changing trend of Al content in each period can be seen from the diagram, and the stacking mode and relative thickness of each period can be generally determined.

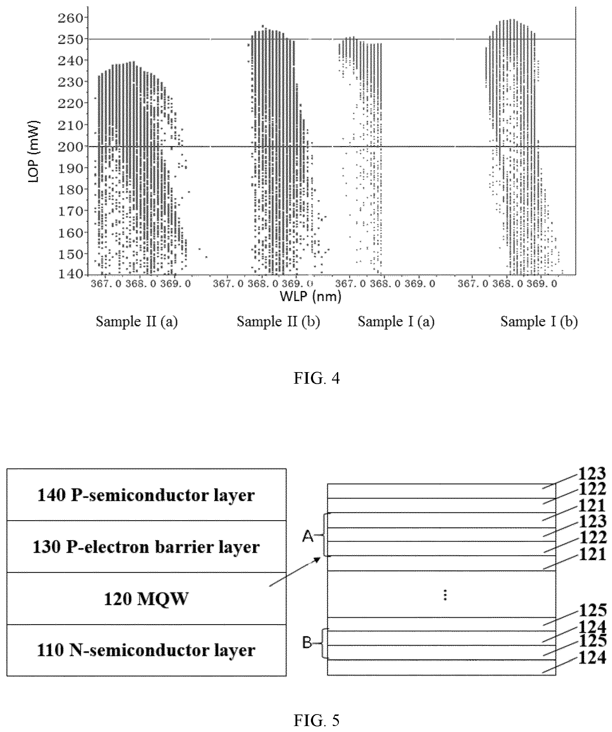

FIG. 4 shows a scatter diagram of wavelength-brightness of sample I (a and b) and sample II (a and b) under current 150mA. Since the tray used for MOCVD growth of an epitaxial wafer is in circular structure and the epitaxial wafers at different positions on the tray results in different growth qualities, the two epitaxial wafers of sample I and the sample II at the same position in the tray are compared. The test data of the solid point on the right indicates the growth samples of the sample I at two positions, and the test data of the solid point on the left indicates the growth samples of the sample II at two positions. It can be seen from FIG. 4 that the light emitting wavelengths of both samples are distributed between 365-370nm. The light emitting brightness of two samples of sample I is obviously higher than that of sample II. That is, the light emitting brightness of sample I is greatly increased, which is higher than the traditional H/C value (less than 70%), and the brightness stability of hot operation is effectively improved.

The above two samples are tested for 48H or 96H with a current of 150mA under the conditions of an ambient temperature of 65 °C and a junction temperature of 125^{°}C, and then applied a reverse voltage of 5V for the aging and leakage current test. △IR represents the difference between the current value at 48H or 96H and the current value of the initial state. The smaller the difference is, the better the quantum well quality of the diode is, and the more difficult it is for the PN junction to conduct current under reverse voltage, which means that the element has more stable reverse characteristics during the use in the subsequent operation. The following parameters are tested. It can be seen from Table 1 below that the aging leakage current of sample I (a, b) is significantly improved.

**Table I**

| Sample | △IR | |
|---|---|---|
| | 48H | 96H |
| Sample I (a) | 0.92 | 1.38 |
| Sample I (b) | 0.93 | 1.40 |
| Sample II (a) | 1.24 | 1.80 |
| Sample II (b) | 1.67 | 2.67 |

In the previous embodiment, the periodic structure of the light emitting layer 120 of the light emitting diode is mainly composed of the first periodic structure A (including the first sub-layer 121, the second sub-layer 122, and the third sub-layer 123).

In another embodiment (second embodiment), the light emitting layer 120 may also be a combined structure. For example, the light emitting layer 120 includes at least a first periodic structure A and a second periodic structure B. All sub-layers of the first periodic structure A may be arranged with reference to the structure of the first embodiment. The second periodic structure B is composed only of a fourth sub-layer 124 and a fifth sub-layer 125. Materials of the fourth and fifth sub-layers may be the same as or different from those of the first sub-layer to the second sub-layer.

In a specific third embodiment, the first periodic structure A is arranged adjacent to the P-type electron barrier layer 130, and the second periodic structure B is arranged adjacent to the N-type conductive layer 110. The fourth sub-layer 124 adopts the same material layer as the first sub-layer 121, and the fifth sub-layer 125 adopts the same material as the second sub-layer 122. For example, the first periodic structure A is the structure of sample I: InGaN/AlGaN/AlN, and its number of periods is two or more, for example, 2-29 periods. The second periodic structure B adopts the structure of InGaN/AlGaN in sample II, and its number of periods is one or more, for example, 1-28 periods, as shown in FIG. 5.

In another specific fourth embodiment, the first periodic structure A is arranged adjacent to the N-type conductive layer 110, and the second periodic structure B is arranged adjacent to the electron barrier layer 130. The fourth sub-layer 124 adopts the same material layer as the first sub-layer 121, and the fifth sub-layer 125 adopts the same material as the second sub-layer 122. For example, the first periodic structure A is the structure of InGaN/AlGaN/AlN in sample I, and its number of periods is two or more, for example, the 2-29 periods. The second periodic structure B adopts the structure of InGaN/AlGaN in sample II, and its number of periods is one or more, for example, 1-28 periods.

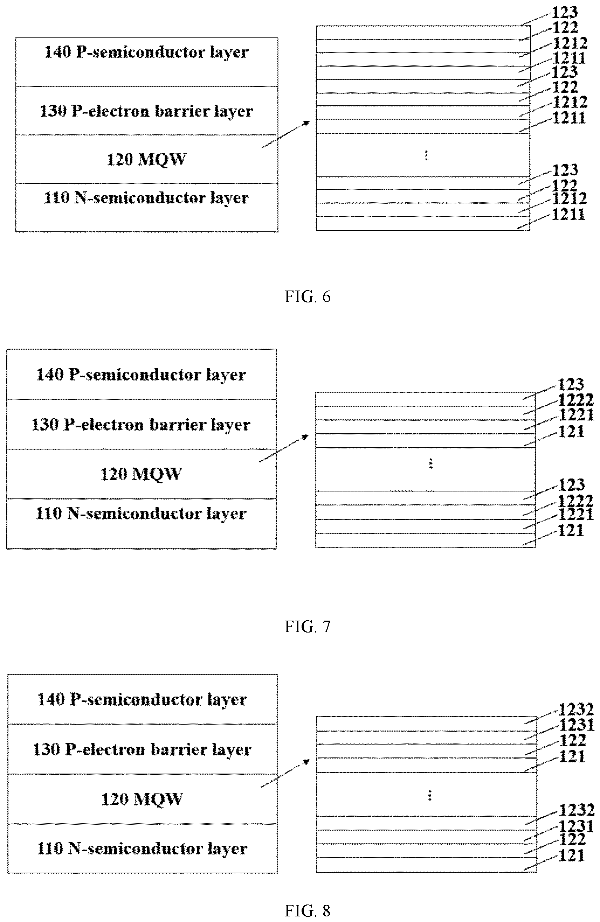

In another specific fifth embodiment, the first sub-layer of at least one periodic structure is formed of a combination of two semiconductor materials, and the stacking order of the two semiconductor layer materials 1211 and 1212 is in the form of Eg from low to high. For example, the at least one periodic structure is in the structure of InGaN/AlGaN/AlN in sample I, and the number of periods is two or more, for example, 2-29 periods. The InₓGa₁₋ₓN in at least one period is stacked with two different contents of In (specifically, x content is 0 to 0.03), as shown in FIG. 6.

In a specific sixth embodiment, the second sub-layer of at least one periodic structure is formed of a combination of two semiconductor materials, and the stacking order of the two semiconductor layers 1221 and 1222 is in the form of Eg from low to high. For example, the at least one periodic structure is in the structure of InGaN/AlGaN/AlN in sample I, and the number of periods is two or more, for example, 2-29 periods. The second sub-layer in at least one period is composed of In_{y}Al_{z}Ga_{1-y-z}N with different y and z. The Eg of at least two semiconductor materials of the second sub-layer is adjusted by an adjustment of In and Al content. More preferably, the y content is between 0 and 0.02 and the z content is between 0.06 and 0.12, as shown in FIG. 7.

In a specific seventh embodiment, the third sub-layer of at least one periodic structure is formed of a combination of two semiconductor materials, and the stacking order of the at least two semiconductor layer materials 1231 and 1232 is in the form of Eg from low to high. For example, the at least one periodic structure is in the structure of InGaN/AlGaN/AlN in sample I, and the number of periods is two or more, for example, 2-29 periods. More preferably, the AlN in at least one period is replaced by a stack combination of AlGaN and AIN, and the Eg of at least two semiconductor materials in the third sub-layer is preferably greater than Eg2 by at least 1.5eV, as shown in FIG. 8.

According to some embodiments of the present invention, a light emitting diode epitaxial wafer for a light emitting diode is provided, which improves the energy bandgap distribution of a periodic structure by adding a semiconductor layer with a high energy bandgap to the traditional multi-quantum well with a periodic structure formed by stacking two semiconductors of potential well and potential barrier, thereby improving light emitting efficiency and leakage function.

The foregoing descriptions are merely preferred embodiments of the present invention. It should be noted that a person of ordinary skill in the art may make some improvements and modifications without departing from the principles of the present invention. These improvements and modifications shall also be considered as the protection scope of the present invention, insofar they fall within the scope of the claims defining the invention.

## Claims

1. A light emitting diode epitaxial wafer, comprising an N-type conductive layer (110), a multi-quantum well (120) and a P-type conductive layer (140), wherein the multi-quantum well (120) comprises at least two periodic structures (A, B), each of which comprises a stacked sequence of a first sub-layer (121), a second sub-layer (122) and a third sub-layer (123), the first sub-layer (121) being a potential well, the second sub-layer (122) being a potential barrier, a relationship among an energy bandgap Eg1 of the first sub-layer (121), an energy bandgap Eg2 of the second sub-layer (122) and an energy bandgap Eg3 of the third sub-layer (123) being Eg1<Eg2<Eg3, the second sub-layer (122) being AlzGa1-zN, 0≤z≤1, the third sub-layer (123) being Al_{w}Ga_{1-w}N, and 0.95≤w≤1,
**characterized in that** a thickness of the first sub-layer (121) is 20-150 angstroms, a thickness of the second sub-layer (122) is 50-300 angstroms, and a thickness of the third sub-layer (123) is less than 30 angstroms;
and the light emitting diode epitaxial wafer is specially adapted for a light emitting diode having a light emitting wavelength of 350-370nm.

2. The light emitting diode epitaxial wafer of claim 1, wherein a difference value between Eg3 and Eg2 is at least 1.5eV.

3. The light emitting diode epitaxial wafer of any one of claims 1 to 2, wherein in the at least one first periodic structure (A) of the multi-quantum well (120), the first sub-layer (121) is further formed by stacking at least two semiconductor materials (1211, 1212), and a stacking manner of the at least two semiconductor materials (1211, 1212) is that energy bandgaps of the at least two semiconductor materials (1211, 1212) increase from low to high in a direction gradually approaching a side of the second sub-layer (122) and are lower than the Eg2 of the second sub-layer (122), and/or
wherein in the at least one first periodic structure (A) of the multi-quantum well (120), the second sub-layer (122) is further formed by stacking at least two semiconductor materials (1221, 1222), and a stacking manner of the at least two semiconductor materials (1221, 1222) is that energy bandgaps of the at least two semiconductor materials (1221, 1222) increase from low to high in a direction gradually away from a side of the first sub-layer (121), and/or
wherein in the at least one first periodic structure (A) of the multi-quantum well (120), the third sub-layer (123) is further formed by stacking at least two semiconductor materials (1231, 1232), and a stacking manner of the at least two semiconductor materials (1231, 1232) is that energy bandgaps of the at least two semiconductor materials (1231, 1232) increase from low to high in a direction gradually away from a side of the second sub-layer (122) and are higher than the Eg2 of the second sub-layer (122).

4. The light emitting diode epitaxial wafer of any one of claims 1-2, wherein at least two periodic structures (A, B) further comprise a second periodic structure (B) that is composed only of a fourth sub-layer (124) with the same material layer as the first sub-layer (121) and a fifth sub-layer (125) with the same material as the second sub-layer (122).

5. The light emitting diode epitaxial wafer of claim 1, wherein the light emitting diode is a gallium nitride light emitting diode.

6. The light emitting diode epitaxial wafer of any one of claims 1-2, wherein the third sub-layer (123) is AIN, and preferably the thickness of the third sub-layer (123) is 10-15 angstroms.

7. The light emitting diode epitaxial wafer of claim 1, wherein the energy bandgap Eg1 of the first sub-layer (121) is 3.3~3.5eV, and/or the energy bandgap Eg2 of the second sub-layer (122) is 3.55~3.9eV.

8. The light emitting diode epitaxial wafer of claim 1, wherein a difference value between the energy bandgap Eg2 of the second sub-layer (122) and the energy bandgap Eg1 of the first sub-layer (121) is 0.25~0.30eV.

9. The light emitting diode epitaxial wafer of claim 1, wherein the first sub-layer (121) is InₓGa₁₋ₓN, and 0≤x≤0.03.

10. The light emitting diode epitaxial wafer of claim 1, wherein the second sub-layer (122) is Al_{z}Ga_{1-z}N, and 0.06≤z≤0.12.

11. A light emitting diode obtained by the light emitting diode epitaxial wafer according to any one of claims 1 to 10.

## Patentansprüche

1. Epitaktischer Wafer für lichtemittierende Diode, umfassend eine N-Typ leitfähige Schicht (110), einen Mehrfach-Quantentopf (120) und eine P-Typ leitfähige Schicht (140), worin der Mehrfach-Quantentopf (120) zumindest zwei periodische Strukturen (A, B) umfasst, jede von welchen eine gestapelte Reihenfolge von einer ersten Unterschicht (121), einer zweiten Unterschicht (122) und einer dritten Unterschicht (123) umfasst, wobei die erste Unterschicht (121) ein potentieller Topf ist, die zweite Unterschicht (122) eine potentielle Barriere ist, eine Beziehung zwischen einer Energiebandlücke Eg1 der ersten Unterschicht (121), einer Energiebandlücke Eg2 der zweiten Unterschicht (122) und einer Energiebandlücke Eg3 der dritten Unterschicht (123) Eg1<Eg2<Eg3 ist, die zweite Unterschicht (122) AlzGa1-zN ist, 0 ≤ z ≤ 1, die dritte Unterschicht (123) Al_{w}Ga_{1-w}N ist, und 0.95 ≤ w ≤ 1,
**dadurch gekennzeichnet, dass** eine Dicke der ersten Unterschicht (121) 20-150 Ångström ist, eine Dicke der zweiten Unterschicht (122) 50-300 Ångström ist und eine Dicke der dritten Unterschicht (123) weniger als 30 Ångström ist;
und der epitaktische Wafer für lichtemittierende Diode speziell für eine lichtemittierende Diode mit einer lichtemittierenden Wellenlänge von 350-370 nm geeignet ist.

2. Epitaktischer Wafer für lichtemittierende Diode nach Anspruch 1, worin ein Unterschiedswert zwischen Eg3 und Eg2 zumindest 1.5eV ist.

3. Epitaktischer Wafer für lichtemittierende Diode nach einem der Ansprüche 1 bis 2, worin in der zumindest einen ersten periodischen Struktur (A) des Mehrfach-Quantentopfes (120) die erste Unterschicht (121) ferner durch Stapeln zumindest zweier Halbleitermaterialien (1211, 1212) ausgebildet wird, und eine Stapelweise der zumindest zwei Halbleitermaterialien (1211, 1212) es ist, dass Energiebandlücken der zumindest zwei Halbleitermaterialien (1211, 1212) von niedrig zu hoch in einer Richtung zunehmen, die sich allmählich einer Seite der zweiten Unterschicht (122) nähert und niedriger sind als die Eg2 der zweiten Unterschicht (122), und/oder
worin in der zumindest einen ersten periodischen Struktur (A) des Mehrfach-Quantentopfes (120) die zweite Unterschicht (122) ferner durch Stapeln zumindest zweier Halbleitermaterialien (1221, 1222) ausgebildet wird, und eine Stapelweise der zumindest zwei Halbleitermaterialien (1221, 1222) es ist, dass Energiebandlücken der zumindest zwei Halbleitermaterialien (1221, 1222) von niedrig zu hoch in einer Richtung zunehmen, die sich allmählich von einer Seite der ersten Unterschicht (121) entfernt, und/oder
worin in der zumindest einen ersten periodischen Struktur (A) des Mehrfach-Quantentopfes (120) die dritte Unterschicht (123) ferner durch Stapeln zumindest zweier Halbleitermaterialien (1231, 1232) ausgebildet wird, und eine Stapelweise der zumindest zwei Halbleitermaterialien (1231, 1232) es ist, dass Energiebandlücken der zumindest zwei Halbleitermaterialien (1231, 1232) von niedrig zu hoch in einer Richtung zunehmen, die sich allmählich von einer Seite der zweiten Unterschicht (122) entfernt und höher sind als die Eg2 der zweiten Unterschicht (122).

4. Epitaktischer Wafer für lichtemittierende Diode nach einem der Ansprüche 1-2, worin zumindest zwei periodische Strukturen (A, B) ferner eine zweite periodische Struktur (B) umfassen, die nur aus einer vierten Unterschicht (124) mit derselben Materialschicht wie die erste Unterschicht (121) und einer fünften Unterschicht (125) mit demselben Material wie die zweite Unterschicht (122) besteht.

5. Epitaktischer Wafer für lichtemittierende Diode nach Anspruch 1, worin die lichtemittierende Diode eine lichtemittierende Diode aus Galliumnitrid ist.

6. Epitaktischer Wafer für lichtemittierende Diode nach einem der Ansprüche 1-2, worin die dritte Unterschicht (123) AlN ist, und vorzugsweise die Dicke der dritten Unterschicht (123) 10-15 Ångström ist.

7. Epitaktischer Wafer für lichtemittierende Diode nach Anspruch 1, worin die Energiebandlücke Eg1 der ersten Unterschicht (121) 3.3~3.5eV ist, und/oder die Energiebandlücke Eg2 der zweiten Unterschicht (122) 3.55~3.9eV ist.

8. Epitaktischer Wafer für lichtemittierende Diode nach Anspruch 1, worin ein Unterschiedswert zwischen der Energiebandlücke Eg2 der zweiten Unterschicht (122) und der Energiebandlücke Eg1 der ersten Unterschicht (121) 0.25∼0.30eV ist.

9. Epitaktischer Wafer für lichtemittierende Diode nach Anspruch 1, worin die erste Unterschicht (121) InₓGa₁₋ₓN ist, und 0 ≤ x ≤ 0.03.

10. Epitaktischer Wafer für lichtemittierende Diode nach Anspruch 1, worin die zweite Unterschicht (122) Al_{z}Ga_{1-z}N ist, und 0.06 ≤ z ≤ 0.12.

11. Lichtemittierende Diode, die durch den epitaktischen Wafer für lichtemittierende Diode nach einem der Ansprüche 1 bis 10 erhalten wird.

## Revendications

1. Plaquette épitaxiale de diode électroluminescente, comprenant une couche conductrice de type N (110), un puits multiquantique (120) et une couche conductrice de type P (140), dans laquelle le puits multiquantique (120) comprend au moins deux structures périodiques (A, B), dont chacune comprend une séquence empilée d'une première sous-couche (121), d'une deuxième sous-couche (122) et d'une troisième sous-couche (123), la première sous-couche (121) étant un puits de potentiel, la deuxième sous-couche (122) étant une barrière de potentiel, une relation entre une bande interdite d'énergie Eg1 de la première sous-couche (121), une bande interdite d'énergie Eg2 de la deuxième sous-couche (122) et une bande interdite d'énergie Eg3 de la troisième sous-couche (123) étant Eg1<Eg2<Eg3, la deuxième sous-couche (122) étant AlzGa1-zN, 0≤z≤1, la troisième sous-couche (123) étant Al_{w}Ga_{1-w}N, et 0.95≤w≤1,
**caractérisée en ce qu'**une épaisseur de la première sous-couche (121) est de 20 à 150 angströms, une épaisseur de la deuxième sous-couche (122) est de 50 à 300 angströms, et une épaisseur de la troisième sous-couche (123) est inférieure à 30 angströms ;
et la plaquette épitaxiale de diode électroluminescente est spécialement adaptée pour une diode électroluminescente ayant une longueur d'onde d'émission de lumière de 350 à 370 nm.

2. Plaquette épitaxiale de diode électroluminescente selon la revendication 1, dans laquelle une valeur de différence entre Eg3 et Eg2 est d'au moins 1.5eV.

3. Plaquette épitaxiale de diode électroluminescente selon l'une quelconque des revendications 1 à 2, dans laquelle dans l'au moins une première structure périodique (A) du puits multiquantique (120), la première sous-couche (121) est en outre formée en empilant au moins deux matériaux semi-conducteurs (1211, 1212), et une manière d'empilage des au moins deux matériaux semi-conducteurs (1211, 1212) est que les bandes interdites d'énergie des au moins deux matériaux semi-conducteurs (1211, 1212) augmentent de faible à élevée dans une direction s'approchant progressivement d'un côté de la deuxième sous-couche (122) et sont inférieures à l'Eg2 de la deuxième sous-couche (122), et/ou
dans laquelle, dans l'au moins une première structure périodique (A) du puits multiquantique (120), la deuxième sous-couche (122) est en outre formée en empilant au moins deux matériaux semi-conducteurs (1221, 1222), et une manière d'empilage des au moins deux matériaux semi-conducteurs (1221, 1222) est que les bandes interdites d'énergie des au moins deux matériaux semi-conducteurs (1221, 1222) augmentent de faible à élevée dans une direction s'éloignant progressivement d'un côté de la première sous-couche (121), et/ou
dans laquelle dans l'au moins une première structure périodique (A) du puits multiquantique (120), la troisième sous-couche (123) est en outre formée en empilant au moins deux matériaux semi-conducteurs (1231, 1232), et une manière d'empilage des au moins deux matériaux semi-conducteurs (1231, 1232) est que les bandes interdites d'énergie des au moins deux matériaux semi-conducteurs (1231, 1232) augmentent de faible à élevée dans une direction s'éloignant progressivement d'un côté de la deuxième sous-couche (122) et sont supérieures à l'Eg2 de la deuxième sous-couche (122).

4. Plaquette épitaxiale de diode électroluminescente selon l'une quelconque des revendications 1 et 2, dans laquelle au moins deux structures périodiques (A, B) comprennent en outre une seconde structure périodique (B) qui est composée uniquement d'une quatrième sous-couche (124) avec la même couche de matériau que la première sous-couche (121) et d'une cinquième sous-couche (125) avec le même matériau que la deuxième sous-couche (122).

5. Plaquette épitaxiale de diode électroluminescente selon la revendication 1, dans laquelle la diode électroluminescente est une diode électroluminescente au nitrure de gallium.

6. Plaquette épitaxiale de diode électroluminescente selon l'une quelconque des revendications 1 et 2, dans laquelle la troisième sous-couche (123) est AlN, et de préférence l'épaisseur de la troisième sous-couche (123) est de 10 à 15 angströms.

7. Plaquette épitaxiale de diode électroluminescente selon la revendication 1, dans laquelle la bande interdite Eg1 de la première sous-couche (121) est de 3.3 ~ 3.5eV, et/ou la bande interdite Eg2 de la deuxième sous-couche (122) est de 3.55 ~ 3.9eV.

8. Plaquette épitaxiale de diode électroluminescente selon la revendication 1, dans laquelle une valeur de différence entre la bande interdite d'énergie Eg2 de la deuxième sous-couche (122) et la bande interdite d'énergie Eg1 de la première sous-couche (121) est de 0.25 ~ 0.30eV.

9. Plaquette épitaxiale de diode électroluminescente selon la revendication 1, dans laquelle la première sous-couche (121) est InₓGa₁₋ₓN, et 0≤x≤0.03.

10. Plaquette épitaxiale de diode électroluminescente selon la revendication 1, dans laquelle la deuxième sous-couche (122) est AlzGa1-zN, et 0.06≤z≤0.12.

11. Diode électroluminescente obtenue par la plaquette épitaxiale de diode électroluminescente selon l'une quelconque des revendications 1 à 10.
